# EUROPEAN PATENT APPLICATION

(11) **EP 1 933 188 A1**
(43) Date of publication of application: **18.06.2008**
(21) Application number: 07119368.4
(22) Date of filing: 26.10.2007
(51) Int. Cl.: G02B 26/08, B81B 3/00

(54) **Non-contact tilting micro mirrors**

(30) Priority: 13.12.2006 US 610464
(71) Applicant: Spatial Photonics, Inc., Sunnyvale, CA 94086 (US)
(72) Inventor: Pan, Shaoher X., San Jose, CA 95120 (US)
(74) Representative: Epping - Hermann - Fischer

(57) **Abstract**

A micro mirror device includes a hinge supported by a substrate and a mirror plate tiltable around the hinge. The hinge includes a length longer than 1 micron, a thickness less than 500 nanometers, and a width less than 1000 nanometers. The hinge can produce an elastic restoring force on the mirror plate when the mirror plate tilts away from an un-tilted position.

## Description

### Background

The present disclosure relates to the fabrication of micro mirrors.
A spatial light modulator (SLM) can be built with an array of tiltable mirror plates having reflective surfaces. Each mirror plate can be tilted by electrostatic forces to an "on" position and an "off" position. The electrostatic forces can be generated by electric potential differences between the mirror plate and one or more electrodes underneath the mirror plate. In the "on" position, the micro mirror plate can reflect incident light to form an image pixel in a display image. In the "off" position, the micro mirror plate directs incident light away from the display image.

### Summary

In one general aspect, a micro mirror device is described that includes a hinge supported by a substrate, wherein the hinge includes a length longer than 1 micron, a thickness less than 800 nanometers, and a width less than 1000 nanometers; and a mirror plate tiltable around the hinge, wherein the hinge can produce an elastic restoring force on the mirror plate when the mirror plate tilts away from an un-tilted position.

In another general aspect, a micro mirror device is described that includes a hinge supported by a substrate, wherein the hinge has a Young's Modulus lower than 150 GPa; and a mirror plate tiltable around the hinge, wherein the hinge can produce an elastic restoring force on the mirror plate when the mirror plate tilts away from an un-tilted position.

In another general aspect, a micro mirror device is described that includes a hinge supported by a substrate, wherein the hinge includes a length longer than 1 micron, a thickness less than 800 nanometers, and a width less than 1000 nanometers; a mirror plate tiltable around the hinge; and a controller that can produce an electric signal to hold the mirror plate at a tilted position at or above 2 degrees relative to the surface of the substrate without causing the mirror plate to contact any structure on the substrate other than the hinge. The hinge can elastically restore the mirror plate to be substantially parallel to the substrate from the tilted orientation.

In another aspect, the disclosed system and methods provide hinges that allow tiltable mirror plates to tilt to large angles at low driving voltages by selecting low rigidity hinge designs or hinge materials. Conditions for the lengths, the thicknesses, the widths, and the elastic constants of the hinges are provided to obtain low rigidity hinge in the tiltable mirror plate.

Implementations of the systems and methods described herein may include one or more of the following features. The hinge may elastically restore the mirror plate to the un-tilted position after the electrostatic force is reduced or removed. The micro mirror device can further include an electrode on the substrate. The controller can apply a voltage to the electrode to produce the electrostatic force. The mirror plate can be substantially parallel to an upper surface of the substrate when in the un-tilted position. The tilt angle at the tilted position can be at or above 3 degrees relative to the un-tilted position. The tilt angle at the tilted position can be at or above 4 degrees relative to the un-tilted position. The hinge can have a length longer than 2 microns. The hinge can have a thickness less than 300 nanometers and a width less than 700 nanometers. The hinge can have a Young's Modulus lower than 150 GPa. The hinge can have a Young's Modulus lower than 100 GPa. The hinge can include aluminum. The hinge can include titanium nitride.

Implementations may include one or more of the following advantages. The present specification discloses a simplified structure for a tiltable mirror plate on a substrate and methods for driving the tiltable mirror plate. The tiltable mirror plate can be tilted to and held at predetermined angles in response to electric signals provided by a controller. No mechanical stop is required on the substrate or on the mirror plate to stop the tilted mirror plate and define the tilt angles of the mirror plate. Eliminating mechanical stops can simplify a micro mirror device, when compared to some micro mirror devices with mechanical stops. The lack of a mechanical contact between the mirror plate and a structure, e.g., a mechanical stop, on the substrate, may also remove the problem of stiction that is known to exist between a mirror plate and mechanical stops in convention mirror devices. Mirror plate devices described herein may tilt to a narrower angle than mirror plates in conventional devices. Less mirror plate tilting can cause less strain on the hinge around which the mirror plate rotates. Such devices may be less likely to experience mechanical breakdown. Thus, the useful lifetime of the device may be longer. Further, because the hinge is not required to rotate as much as in some devices, a greater variety of materials may be selected for hinge formation. Moreover, because the mirror plate undergoes a smaller angular deflection, it can operate at higher frequencies.

Although the invention has been particularly shown and described with reference to multiple embodiments, it will be understood by persons skilled in the relevant art that various changes in form and details can be made therein without departing from the spirit and scope of the invention.

The present application claims the priority of the US patent application 11/610,464 filed December 13, 2006. The disclosure content of this application is hereby incorporated by reference.

### Brief Description of the Drawings

The following drawings, which are incorporated in and form a part of the specification, illustrate embodiments of the present invention and, together with the description, serve to explain the principles of the invention.

Figure 1 is a perspective view of a micro mirror.

Figure 2 is an exploded view of the micro mirror of Figure 1.

Figure 3 is a side view of the micro mirror of Figure 1.

Figures 4A and 4B illustrate the reflections of incident light in the "on" direction and the "off" direction respectively by the tilted mirror plate.

Figure 5 illustrates the reflection of a laser-emitted incident light by a tilted mirror plate.

Figure 6 illustrates the reflection of a light-emitting-diode emitted incident light by a tilted mirror plate.

Figure 7 illustrates an arrangement of an image projection system including micro mirrors.

Figure 8 illustrates the temporal profiles of the driving voltage pulses and the resulting tilt angles in the mirror plate.

Figure 9 is a graph illustrating a response curve of the tilt angle of a mirror plate as a function of the driving voltage for contact and non-contact micro mirrors.

Figure 10 is a graph illustrating stress-distortion responses of hinge materials suitable for non-contact and contact micro mirrors.

Figure 11 is a graph illustrating response curves of the mirror-plate tilt angle as a function of a normalized driving voltage for hinge components having different material compositions.

Figure 12 is a graph illustrating response curves of the mirror-plate tilt angle as a function of the driving voltage for hinge components having different material compositions.

Figure 13 is a graph illustrating response curves of the mirror-plate tilt angle as a function of the driving voltage for hinge component having different rigidities.

Figure 14 is an enlarged view of the elongated hinge in the micro mirror of Figure 2.

### Detailed description

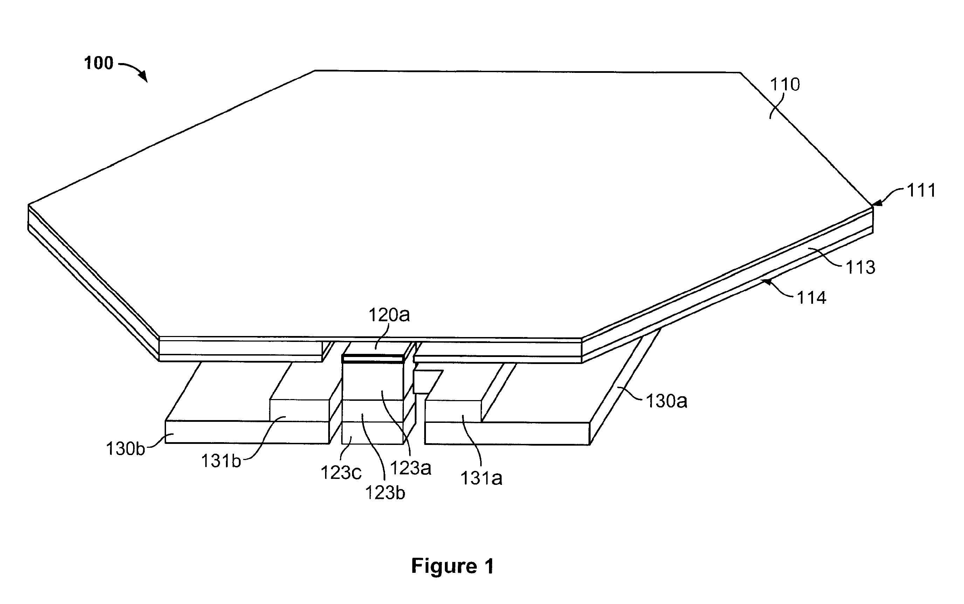

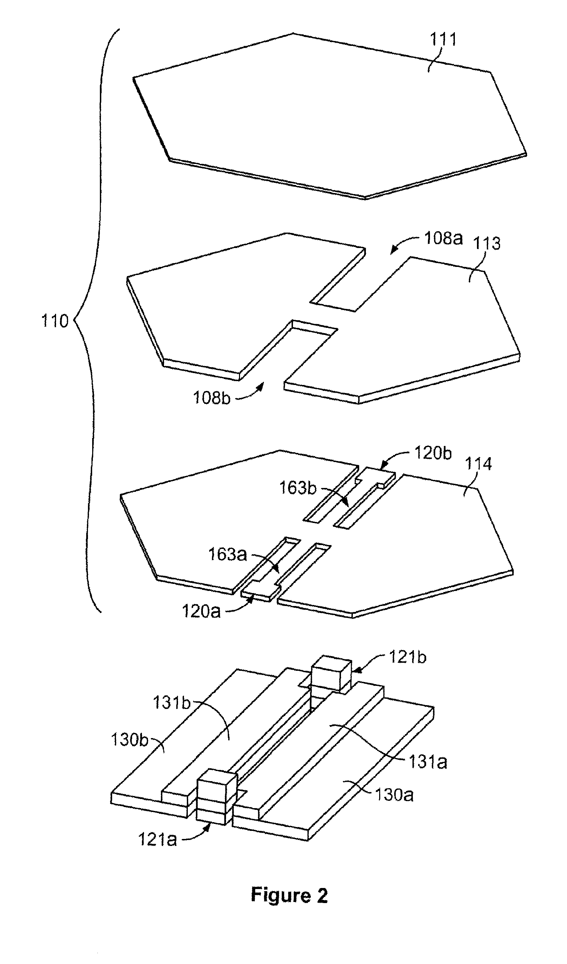

Referring to Figures 1-3, a micro mirror 100 can include a mirror plate 110 over a substrate 300. The mirror plate 110 can include a reflective layer 111, a spacer layer 113, and a hinge layer 114. In some embodiments, the spacer layer 113 includes a pair of openings 108a and 108b. In some embodiments, the hinge layer 114 includes two hinge components 120a and 120b. The hinge components 120a and 120b are connected with the main portion of the hinge layer 114 by elongated hinges 163a and 163b respectively. The elongated hinges 163a and 163b are separated from the main portion of the hinge layer 114 by gaps on the two sides of the elongated hinges 163a or 163b. The mirror plate 110 is at an un-tilted position when no an external force is applied to the mirror plate 110. The un-tilted position can be substantially parallel to the upper surface of the substrate. The mirror plate 110 can be tilted about an axis defined by the two hinge components 120a and 120b. One hinge component 120a (or 120b) is connected to a hinge support post 121a (or 121b) on the substrate 300. The hinge support post 121a can be formed as a unitary member, or include two or three portions. For example, the hinge support post 121 a can include an upper portion 123a, a middle portion 123b, and a lower portion 123c that can be formed in separate deposition steps.

The micro mirror 100 can further include a two-part electrode with a lower portion 130a and an upper portion 131a on one side of the hinge support posts 121a, 121b, and another two-part electrode with lower portion 130b and upper portion 131b on the other side of the hinge support posts 121a, 121b. The electrode lower portions 130a, 130b can be formed by patterning and etching a same conductive layer. The electrode upper portions 131 a, 131b can be formed from another conductive layer over the electrode lower portions 130a, 130b. The hinge support posts 121a, 121b are connected to a control line 311, the two-part electrode 130a, 131a is connected to a control line 312, and the two-part electrode 130b, 131b is connected to a control line 313. The electric potentials of the control lines 311, 312, 313 can be separately controlled by external electric signals provided by a controller 350. The potential difference between the mirror plate 110 and the two-part electrodes 130a, 131a or two-part electrodes 130b, 131b can produce an electrostatic torque that can tilt the mirror plate 110.

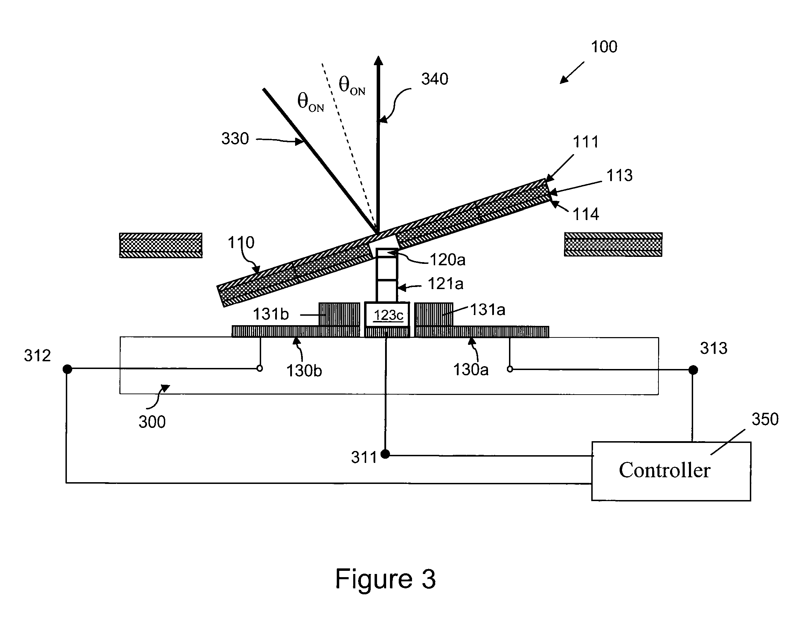

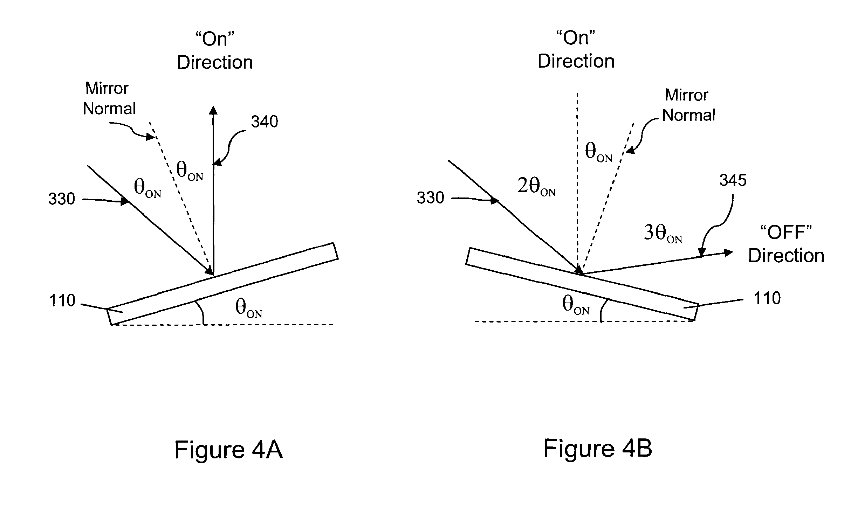

Referring to Figures 3 and 4A, the controller 350 can produce an electrostatic force to overcome an elastic restoring force produced by the distorted elongated hinges 163a or 163b to tilt the mirror plate from the un-tilted position to a tilted position. The tilted position can be an "on" position or an "off" position. The electrostatic force can counter the elastic restoring force to hold the mirror plate at the "on" position or the "off" position. The un-tilted position can be different from the "on" position and the "off" position. In some embodiments, the un-tilted position can also be the same as the "on" or the "off" positions. The mirror plate 110 can tilt in one direction from the un-tilted position to a tilt angle θ₁ relative to the substrate 300. The mirror plate 110 can reflect an incident light 330 to form reflected light 340 traveling in the "on" direction such that the reflected light 340 can arrive at a display area to form a display image. The "on" direction can be perpendicular to the substrate 300. Because the incident angle (i.e., the angle between the incident light 330 and the mirror normal direction) and the reflection angle (i.e. the angle between the reflected light 340 and the mirror normal direction) are the same, the incident light 330 and the reflected light 340 form an angle 2θ₁ that is twice as large as the tilt angle θₒₙ of the mirror plate 110.

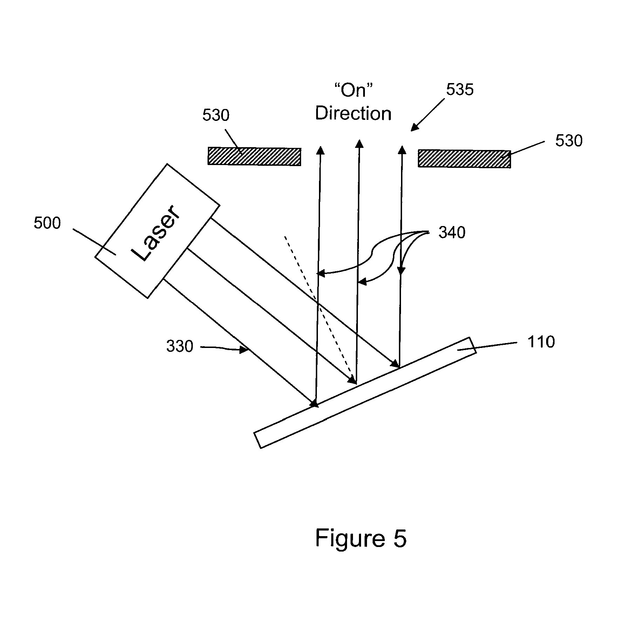

Referring to Figure 4B, the mirror plate 110 can symmetrically tilt in the opposite direction to an orientation also at a tilt angle θ₁ relative to the substrate 300. The mirror plate 110 can reflect the incident light 330 to form reflected light 345 traveling in the "off" direction. The reflected light 345 can be blocked by an aperture (530 in Figures 5-7) and absorbed by a light absorber. Because the incident angle for the incident light 330 is 3θ₁, the reflection angle should also be 3θ₁. Thus the angle between the reflected lights 340, 345 is 4θ₁, four times as large as the tile angle θ₁ of the mirror plate 110.

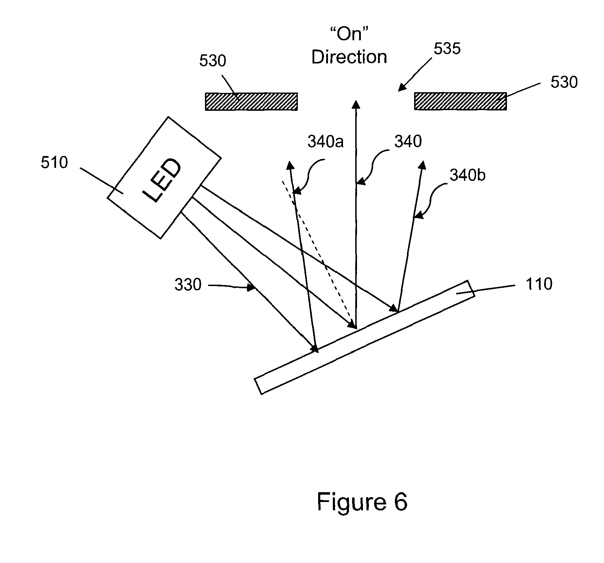

The incident light 330 can be provided by different light sources, such as a laser 500 or light emitting diode (LED) 510, as respectively shown in Figures 5 and 6. The incident light emitted by the laser 500 is coherent and can remain collimated after the reflection by the mirror plate 110. An aperture 530, the laser 500, and the mirror plate 110 can be arranged such that almost all the reflected light 340 reflected by the mirror plate 110 when tilted in the "on" direction passes through an opening 535 in the aperture 530. The incident light 330 emitted from the LED 510 is generally non-coherent and tends to diverge over distance.
The aperture 530, the LED 510, and the mirror plate 110 can be arranged such that a majority of the light reflected by the mirror plate 110 at the "on" position passes through the opening 535 in the aperture 530. For example, the reflected light 340 can go through the opening 535, while the reflected light 340a and 340b, which diverges away from reflected light 340, is blocked by the aperture 530.

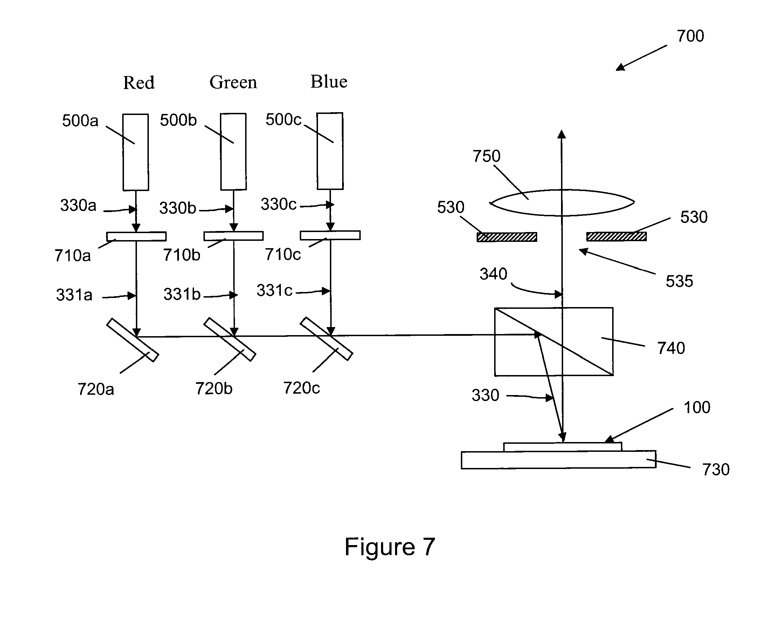

An exemplary image projection system 700 based on an array of micro mirrors 100 is shown in Figure 7. Red, green, and blue lasers 500a, 500b and 500c can respectively emit red, green, and blue colored laser beams 330a, 330b, and 330c. The red, green, and blue colored light 330a, 330b, and 330c can pass through diffusers 710a, 710b, and 710c to form colored light 331a, 331b, and 331c. The diffusers 710a, 710b, and 710c can resize (e.g. expand) and can shape the laser beams 330a, 330b, and 330c to cross-sectional shapes that are compatible with the array of micro mirrors 100. For example, the colored light 331a, 331b, and 331c can be shaped to be rectangular, which can be more compatible with the shape of the array of micro mirrors 100. The colored light 331a, 331b, and 331c can then be reflected by beam splitters 720a, 720b, and 720c (which function as beam combiners), and merged into a color incident light 330. In some embodiments, the color incident light 330 can be reflected by a total internal reflection (TIR) prism 740 to align the direction of the color incident light 330 to illuminate micro mirrors 100 on a support member 730. The reflected light 340 deflected by the mirror plates 110 at the "on" positions can pass through the TIR prism 740 and the opening 535 of the aperture 530, and be projected by a projection system 750 to form a display image.

The relative locations of the aperture 530, the TIR prism 740, and the micro mirror 100 can be arranged such that almost all the reflected light 340 in the "on" direction can pass through the opening 535 and all the reflected light 345 in the "off" direction can be blocked by the aperture 530. Any portion of the reflected light 340 blocked by the aperture 530 is a loss in the display brightness. Any stray reflected light that passes through the opening 535 will decrease the contrast of the display image. The larger the angular spread between the reflected light 340 and the reflected light 345, the easier it is to separate the reflected light 340 and the reflected light 345 to achieve the maximum brightness and contrast in the display image. In other words, the larger the tilt angles θₒₙ (or θ_{off}) in the display system 700, the easier it is to separate the reflected light 340 and the reflected light 345 such that substantially all the reflected light 345 is blocked and substantially all the reflected light 340 arrives at the display surface to form the display image.

In some micro mirror devices, the tilt movement of the mirror plates is stopped by the mechanical stops. The "on" and "off" positions of a tiltable mirror plate are defined by the mirror plate's orientation when it is in contact with a mechanical stop. In contrast, the micro mirror 100 does not include mechanical stops that can limit the tilt movement of the mirror plate 110. Rather, the "on" and "off" positions of the mirror plate 110 are controlled by a driving voltage applied to the mirror plate 110 and the two-part electrodes 130a, 131a, 130b, and 131b. For this reason, the disclosed mirror plate 110 can be referred as "non-contact" micro mirrors. The conventional mirror systems that utilize mechanical stops or include a mirror plate that contacts the substrate when in a tilted position can be referred as "contact" micro mirrors.

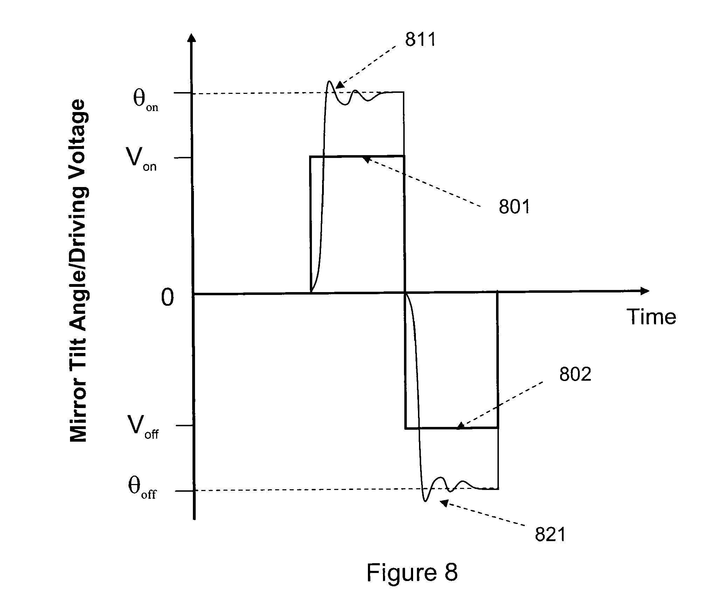

A positive driving voltage pulse 801 and a negative driving voltage pulse are shown in Figure 8, on a graph that indicates mirror tilt angle. A zero tilt angle corresponds to a non-tilt state (commonly at the horizontal orientation) at which the mirror plate is parallel to the surface of the substrate. The mirror plate does not experience any elastic restoring force at the non-tilt state. The positive driving voltage pulse 801 includes a driving voltage Vₒₙ and is used to control the mirror plate to the "on" position. The positive voltage pulse 801 can create an electrostatic force that tilts the mirror plate in the "on" direction, which is a counter clockwise direction in the figures, to a tilt angle θ₁ relative to the upper surface of the substrate. As the mirror plate tilts, the mirror plate experiences an elastic restoring force, created by the torsional distortion of the elongated hinges, which applies a force on the mirror plate, such as in the clockwise direction. Although the electrostatic force increases somewhat as the tilt angle increases, the elastic restoring force increases more rapidly as a function of the tilt angle than the electrostatic force. The mirror plate eventually stops at the tilt angle θₒₙ when the elastic restoring force becomes equal to the electrostatic force. In other words, the mirror plate is held at the tilt angle θₒₙ by a balance between the electrostatic force and the elastic restoring force that apply forces on the mirror plate in the opposite directions. The mirror plate may initially oscillate around the average tilt angle θₒₙ in a region 811 and subsequently settle to stay at the tilt angle θₒₙ.

Similarly, a negative driving voltage pulse 802 is used to control the mirror plate to the "off" position. The voltage pulse 802 includes a driving voltage V_{off}. The voltage pulse 802 can create an electrostatic force to tilt the mirror plate in the "off" direction, such as in a clockwise direction, to a tilt angle θ_{off} relative to the upper surface of the substrate. Again, the mirror plate does not experience any elastic restoring force at the non-tilt position. As the tilt angle increases, the elastic restoring force is created by the torsional distortions of the elongated hinges, which applies a force that is in a counter clockwise direction. The elastic restoring force increases more rapidly as a function of the tilt angle than the electrostatic force. The mirror plate eventually stops at the tilt angle θ_{off} when the elastic restoring force becomes equal to the electrostatic force. The mirror plate is held at the tilt angle θ_{off} by a balance between the electrostatic force created by the negative voltage pulse 802 and the elastic restoring force by the distorted elongated hinges. The mirror plate may initially oscillate around the average tilt angle θ_{off} in a region 821 and then settle to stay at the tilt angle θ_{off}. The tilt angles θₒₙ and θ_{off} can have equal magnitude or can have different magnitude. After the negative driving voltage pulse 802 is removed, the mirror plate can be elastically pulled back to zero tilt angle (i.e. the horizontal orientation) by the elongated hinges.

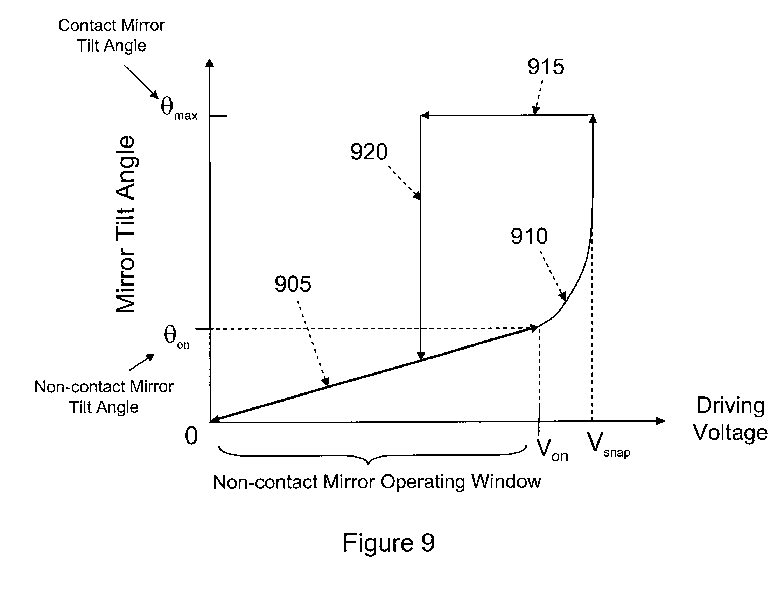

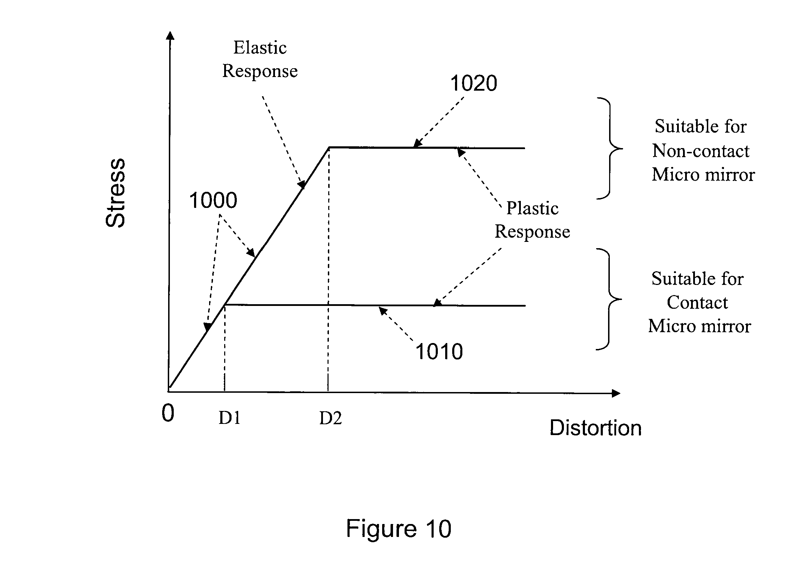

A response curve of the tilt angle of a mirror plate as a function of a driving voltage is shown in Figure 9. The response curve includes the tilt-angle range for a non-contact micro mirror. For comparison, the response curve also depicts the tilt-angle range for a contact-type micro mirror. The tilt angle of the mirror plate first gradually increases as a function of the driving voltage along a curve 905. The tilt angle then rapidly increases along a curve 910 as the driving voltage increases until the mirror plate "snaps" at a snapping voltage Vₛₙₐₚ at which the elastic restoring force stops increasing as the tilt angle increases. The electrostatic force continues to increase as the tilt angle increases. The imbalance between the stronger electrostatic force and the constant plastic restoring force (see Figure 10) sharply increases the tilt angle to θₘₐₓ at which the tilt movement of the mirror plate is stopped by a mechanical stop on the substrate. In the present specification, the term "snap" refers to the unstable state of imbalanced mirror plate of the mirror plate wherein the mirror plate rapidly tilts until it is stopped by a fixed object.

The "snapping" of the mirror plate is a result of the mechanical properties of the hinge in a micro mirror. Referring to Figure 10, stress on a mirror plate can be caused, for example, by an electrostatic force between the mirror plate and an electrode on the substrate. The distortion of a hinge increases with stress along the curve 1000 in the low stress range. The curve 1000 represents the hinge's elastic response to the stress. In a micro mirror having one exemplary hinge material, the hinge snaps at a distortion D1. In other words, the elastic restoring force stops increasing as the tilt angle increase above the tilt angle corresponding to D1. The curve 1010 represents a plastic region of the hinge material. This hinge material is suitable to be used in a contact-type of micro mirror.

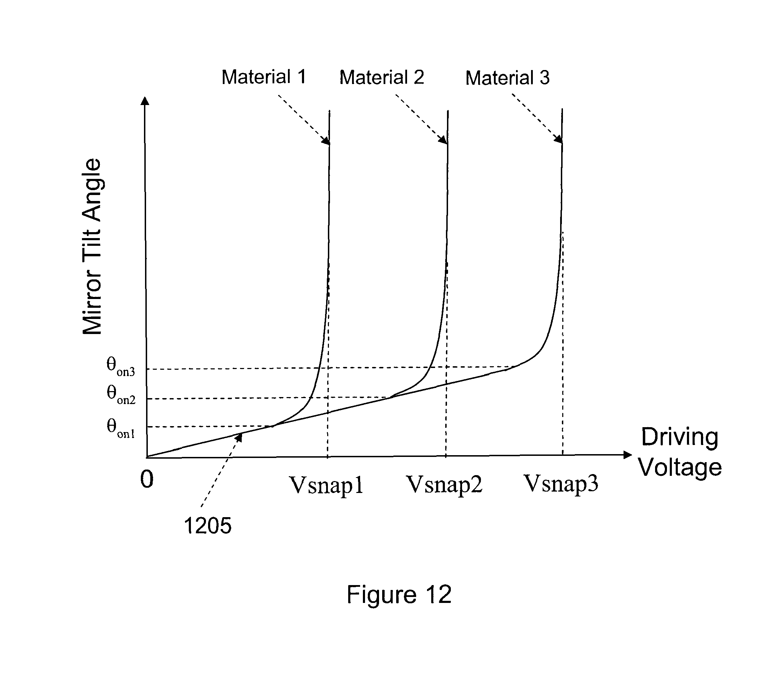

As discussed previously in relation with Figure 7, non-contact micro mirrors preferably have tilt angles such as about 2°, about 3°, about 4°, about 5°, or higher for optimal brightness and contrast in the display images. Such tilt angles can separate the incoming lights into the "on" and the "off" directions. A large "on" or "off" tilt angle also requires a wide angular range in which the mirror plate can be tilted and then can be elastically restored by the hinge back to the non-tilt position. Figure 10 shows the stress-distortion response curve of another exemplary hinge material that transitions from the elastic response curve 1000 to a plastic response curve 1020 at a distortion D2 > D1. The micro mirror has a wider range for elastic hinge distortion and is thus more suitable for non-contact mirror applications. The difference between D2 and D1 can result from differences in material compositions of the mirror plate 110 (as shown in Figure 12). A contact micro mirror, in contrast, can have a narrow range for elastic hinge distortion such that a relatively small driving voltage can snap the mirror plate to cause the plate to contact the mechanical stops. The micro mirror corresponding to the plastic curve 1010 is thus more suitable for a contact micro mirror. One example of a hinge material suitable for the "non-contact" micro mirror in the micro mirror 100 is an aluminum titanium nitride that has a nitrogen composition in the range of about 0 to 15%, or 0 to 10%, and/or approximately equal compositions for aluminum and titanium. One example for the hinge material made of the aluminum titanium nitride compound is Al_{48%} Ti_{48%} N_{4%}.

Referring back to Figure 9, after the micro mirror snaps at the tilt angle θₘₐₓ, the mirror plate initially stays in contact with the mechanical stop within the drive voltage range indicated by line 915 as the driving voltage decreases. After the hinge returns to an elastic region, restores its elasticity, and can overcome stiction at the mechanical stop, the mirror plate finally tilts back along the response curve 905, where the drive voltage intersects with the line 920. The hysteresis represented by the curves 905, 910 and lines 915, 920 is a common property of the contact micro mirrors. The operational window for a non-contact micro mirror is along the curve 905 in the elastic region of the mirror plate. The mirror plate can be tilted and held at a tilt angle θₒₙ or θ_{off} by a driving voltage Vₒₙ. The mirror plate can be elastically restored back to the original position by the hinges 163a and 163b along the same the response curve 905 after the electrostatic force is removed. There is no substantial hysteresis associated with the non-contact micro mirror 100 disclosed in the present specification.

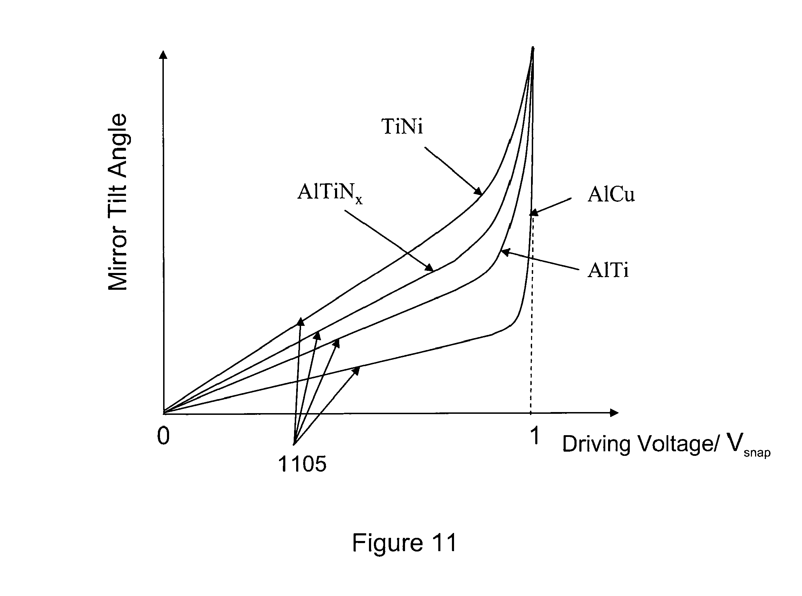

Figure 11 illustrates response curves of mirror-plate tilt angle as a function of driving voltage for hinges having different material compositions. The normalized driving voltage is simply the driving voltage divided by the mirror-snapping voltage. The mirror-plate tilt angles for hinges having the different material compositions can rise along different curves 1105 as a function of the normalized driving voltage. The tilt angles are higher for hinges made of an TiNi alloy, an AlTiN compound, and an AlTi alloy than for hinges made of AlCu. The above described hinge materials can include the following exemplified compositions: Ti_{50%}Ni_{50%} for the TiNi alloy, Al_{48%}Ti_{48%}N_{4%} for the AlTiN compound, Al_{50%}Ti_{50%} for the AlTi alloy, and Al_{90%}Cu_{10%} for the AlCu alloy.

As described above, the mirror plates can be tilted in the angular ranges as defined by the cures 1105 and elastically restored to their respective non-tilt positions. The ranges of the tilt angles available for the curves 1105, at which the non-contact micro mirrors operate, are different for the depicted material compositions. In the particular examples depicted in Figure 11, a hinge made of Ti_{90%}Ni_{10%} allows a non-contact mirror plate to tilt and elastically restore in a wider angular range than the other two hinge material compositions.

The hinge materials compatible with the micro mirror can include a range of materials such as titanium, gold, silver, nickel, iron, cobalt, copper, aluminum or a combination thereof. The hinge can also include some amount of oxygen or nitrogen, for example, when one or more metals, such as two metals, are deposited using physical vapor deposition in a nitrogen or oxygen atmosphere, the deposited compound or alloy can include some amount of oxygen or nitrogen. The hinges can be made of TiNi, wherein the titanium composition can be between about 30% and 70%, or between about 40% and 60%, or between about 45% and 55%. The hinges can be made of AlTi, wherein the titanium composition can be between about 30% and 70%, or between about 40% and 60%, or between about 45% and 55%. The suitable hinge material for the "non-contact" micro mirror can also include aluminum titanium nitride that has a nitrogen composition in the range of between about 0 and 10%, or between about 0 and 15%, and approximately equal compositions for aluminum and titanium. A hinge composed of aluminum titanium nitride can be substantially free of other elements (in this context, substantially free means that other elements might be present in trace amounts consistent with the fabrication process), and in particular can be substantially free of oxygen.

Referring to Figure 12, the mirror-plate tilt angles having hinges made of three different materials Material 1, Material 2, and Material 3 may initially gradually rise along the same curve 1205. The snap voltages Vₛₙₐₚ₁, Vₛₙₐₚ₂ and Vₛₙₐₚ₃ for the hinge made of Material 1, Material 2, and Material 3 may be different: Vₛₙₐₚ₁ < Vₛₙₐₚ₂ < Vₛₙₐₚ₃. The operational windows for non-contact tilt angles θₒₙ₁, θₒₙ₂, and θₒₙ₃ corresponding to the hinge materials are also different: θₒₙ₁ < θₒₙ₂ < θₒₙ₃. In the examples depicted in Figure 12, Material 3 is more preferred as the hinge material for the non-contact mirrors because it can provide the largest angular range for the mirror plate's tilt and restoring to the non-tilt position. For example, the hinge made of the Material 3 can elastically restore the mirror plate from a first orientation at or above 2 degrees, 3 degrees, or 4 degrees, relative to the non-tilt position.

The above described micro mirrors provide a simplified structure for a tiltable mirror plate on a substrate and methods for driving the tiltable mirror plate. The tiltable mirror plate can be tilted to and held at predetermined angles in response to electric signals provided by a controller. No mechanical stop is required on the substrate or on the mirror plate to stop the tilted mirror plate and define the tilt angles of the mirror plate. Eliminating mechanical stops not only simplifies a micro mirror device, but also removes the stiction that is known to exist between a mirror plate and mechanical stops in some mirror devices. Mirror plate devices described herein may tilt to a narrower angle than mirror plates in other devices. Less mirror plate tilting can cause less strain on the hinge around which the mirror plate rotates. Such devices may be less likely to experience mechanical breakdown. Thus, the useful lifetime of the device may be longer. Further, because the hinge is not required to rotate as much as in conventional devices, a greater variety of materials may be selected for hinge formation. Moreover, because the mirror plate undergoes a smaller angular deflection, it can operate at higher frequencies.

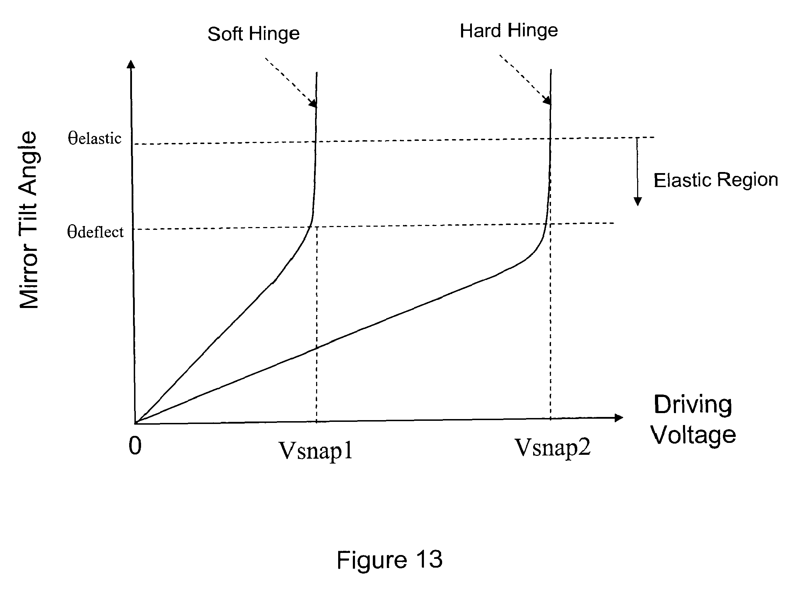

Referring now to Figure 13, in other embodiments, the tilt angle of the mirror plate 110 depends on the rigidity of the hinge 163a or 163b. The curve labeled by "hard hinge" is the mirror tilt-angle response to a driving voltage for a hinge having a relatively high rigidity. The responsive curve is approximately linear at low driving voltage. The mirror plate snaps when the driving voltage approaches a snap voltage Vₛₙₐₚ₂, forming a deflection point at tilt angle θ_{deflect}. Above θ_{deflect}, the mirror tilt angle rapidly increases with slight increase in the driving voltage. The mirror plate can be elastically restored at mirror tilt angles below θ_{elastic}, including the tilt-angle range between θ_{deflect} and θ_{elastic}. The hinge becomes plastic when the mirror tilt angle exceeds θ_{elastic}, wherein the mirror plate cannot be restored to an un-tilted position by the elastic restoring force of the hinge. An external force such as an electrostatic force is required to restore the mirror plate back to the un-tilted position. An exemplified voltage for Vₛₙₐₚ₂ can be approximately 15 volts. θ_{deflect} can be approximately 4 degrees.

The curve labeled by "soft hinge" is the mirror tilt-angle response to a driving voltage for a hinge having a relatively low rigidity. The responsive curve is approximately linear at low driving voltage. The mirror plate snaps when the driving voltage approaches Vₛₙₐₚ₁ at tilt angle θ_{deflect}. Above θ_{deflect}, the mirror tilt angle increases rapidly with the driving voltage.
The mirror plate can be elastically restored at mirror tilt angles below θ_{elastic} (above θ_{deflect}). When the mirror tilt angle exceeds θ_{elastic}, the hinge becomes plastic and cannot restore the tilt of the mirror plate with the elastic restoring force. An exemplified snap voltage Vₛₙₐₚ₁ for a soft hinge can be below 10 volts, or at 5 volts or below.

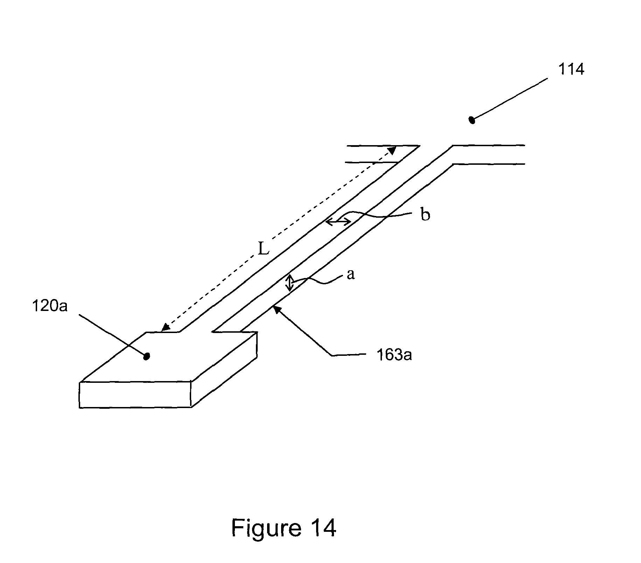

The rigidity of a hinge 163a or 163b in a mirror plate 110 can be dependent on several factors such as the dimensions and the elastic modulus of the hinge. Referring to Figure 14, a hinge 163a can be formed in an elongated shape having a length "L", a width "b", and a thickness "a". A hinge is less rigid with a longer length "L", narrower width "b", and thinner thickness "a". For example, a soft hinge 163a can have a thickness "a" in the range of about 30 to 800 nanometers, or between about 600 and 800 nanometers, or less than about 700 nanometers, less than 600 nanometers or less than 500 nanometers, width "b" in the range of about 50 to 1000 nanometers, and a length "L" in the range of about 1-10 microns. Moreover, the Young's Modulus of the hinge material is preferably kept below 150 GPa to lower the rigidity of the hinge. Suitable materials can include titanium (with a Young's Modulus of approximately 110 GPa) and titanium nitride (with Young's Modulus in the range of 120 - 146 GPa). The rigidity of the hinge can be further reduced by selecting a hinge material having a Young's Modulus below 100 GPa and above 5 GPa. For example, a material suitable for the hinge can include aluminum that has a Young's Modulus at about 70 GPa.

It is understood that the disclosed methods are compatible with other configurations of micro mirrors. Different materials than those described above can be used to form the various layers of the mirror plate, the hinge connection post, the hinge support post, the electrodes and the mechanical stops. The electrodes can include several steps as shown in the figures, or a single layer of conductive material. The mirror plate can have different shapes such as, rectangular, hexagonal, diamond, or octagonal. The driving voltage pulses can include different waveforms and polarities. The display system can include different configurations and designs for the optical paths without deviating from the spirit of the present invention. In any instance in which a numerical range is indicated herein, the numerical endpoints can refer to the number indicated or about the number indicated. That is, when a composition has between X and Y% or from X to Y% of a component, it can have between X and Y% or in the range of about X to about Y % of the component.

## Claims

1. A micro mirror device, comprising:
a hinge supported by a substrate, wherein the hinge comprises a length longer than 1 micron, a thickness less than 800 nanometers, and a width less than 1000 nanometers; and
a mirror plate tiltable around the hinge, wherein the hinge is configured to produce an elastic restoring force on the mirror plate when the mirror plate tilts away from an un-tilted position.

2. The micro mirror device of claim 1, wherein the hinge comprises a length longer than 2 microns.

3. The micro mirror device of claim 1 or 2, wherein the hinge comprises a thickness less than 300 nanometers and a width less than 700 nanometers.

4. The micro mirror device of one of claim 1 to 3, wherein the hinge has a Young's Modulus lower than 150 GPa.

5. A micro mirror device, comprising:
a hinge supported by a substrate, wherein the hinge has a Young's Modulus lower than 150 GPa; and
a mirror plate tiltable around the hinge, wherein the hinge is configured to produce an elastic restoring force on the mirror plate when the mirror plate tilts away from an un-tilted position.

6. The micro mirror device of claim 5, wherein the hinge comprises a length longer than 1 micron, a thickness less than 500 nanometers, and a width less than 1000 nanometers.

7. The micro mirror device of claim 5 or 6, wherein the hinge comprises a length longer than 2 micron, a thickness less than 300 nanometers, or a width less than 700 nanometers.

8. The micro mirror device of one of claims 1 to 7, further comprising a controller configured to produce an electrostatic force to overcome the elastic restoring force to tilt the mirror plate from the un-tilted position to a tilted position.

9. The micro mirror device of claim 8, wherein the controller is configured to produce an electrostatic force to counter the elastic restoring force to hold the mirror plate at the tilted position.

10. The micro mirror device of one of claims 1 to 9, wherein the hinge is configured to elastically restore the mirror plate to the un-tilted position after the electrostatic force is reduced or removed.

11. The micro mirror device of one of claims 1 to 10, further comprising an electrode on the substrate, wherein the controller is configured to apply a voltage to the electrode to produce the electrostatic force.

12. The micro mirror device of one of claims 1 to 11, wherein the mirror plate is substantially parallel to an upper surface of the substrate when in the un-tilted position.

13. The micro mirror device of one of claims 1 to 12, wherein the tilt angle at the tilted position is at or above 3 degrees relative to the un-tilted position.

14. The micro mirror device of claim 13, wherein the tilt angle at the tilted position is at or above 4 degrees relative to the un-tilted position.

15. The micro mirror device of one of claims 1 to 14, wherein the hinge has a Young's Modulus lower than 100 GPa.

16. The micro mirror device of one of claims 1 to 15, wherein the hinge comprises aluminum.

17. The micro mirror device of one of claims 1 to 16, wherein the hinge comprises titanium nitride.
